# EUROPEAN PATENT SPECIFICATION

(11) **EP 3 095 757 B1**
(45) Date of publication and mention of the grant of the patent: **05.12.2018**
(21) Application number: 16169401.3
(22) Date of filing: 12.05.2016
(51) Int. Cl.: B81C 1/00, H01L 23/64

(54) **CHIP HAVING STRUCTURES THEREON**
CHIP MIT AUFGESETZTEN STRUKTUREN
PUCE AYANT UNE SURFACE MUNIE DE STRUCTURES

(30) Priority: 21.05.2015 US 201514718152
(43) Date of publication of application: 23.11.2016
(73) Proprietor: ams International AG, 8640 Rapperswil-Jona (CH)
(72) Inventor: Daamen, Roel, 6075 AB Herkenbosch (NL); Bouman, Hendrik, 6525 PA Nijmegen (NL); Vijayakumar, Kailash, Singapore 460055 (SG)
(74) Representative: Epping - Hermann - Fischer

(56) References cited:
- WO-A1-01/85600
- WO-A1-02/059679
- WO-A1-2014/209358
- US-A1- 2006 049 525

## Description

Pressure sensors and other devices with cavities and membranes can be susceptible to damage during later wafer and chip processing steps. WO 2014/209358 A1 discloses a chip comprising a substrate and a device, having a device height, a membrane and a cavity. The chip also comprises a set of structures coupled to the device side and configured to have a structure height greater than or equal to the device height. Said structures are solder bumps which are arranged at least on four sides of the device. The substrate includes an integrated circuit.

Pressure sensors fabricated within a silicon substrate tend to be the best protected and thus are less susceptible to damage during later back-end processing. Such back-end processing can include back-grinding for substrate thinning.

WO 01/85600 A1 teaches a method for fabricating a chip having a MEMS element which involves applying a tape to a first side of the chip and grinding a second side of the chip.

Pressure sensors fabricated as standalone modules on separate substrates, which are then capped with a silicon, are also less susceptible to damage if they are not further processed.
It is an object of the present specification to suggest an improved chip and a method for fabricating a chip which are less prone to damage during wafer and chip processing steps.
This objective is achieved by the subject matter of the independent claim. Further developments and embodiments are described in dependent claims.

An example embodiment of the invention comprises a chip further comprising a substrate. A first side of a passivation layer is coupled to the substrate. A device has a device height, a membrane and a cavity. A first device surface is coupled to a second side of the passivation layer which is opposite to the first side of the passivation layer. A set of structures is coupled to the chip as specified more closely in claim 1 and configured to have a structure height greater than or equal to the device height.
Devices such as pressure sensors (PS) are often integrated on top of a passivation layer or a passivation stack to enable high density monolithic transducer integration, e.g. an ASIC pressure sensor. As a consequence the device sticks out of a main surface of the chip and makes it more susceptible to mechanical stress during manufacturing steps such as grinding, thinning, taping or de-taping. For example, if only a single transducer is implemented per die, density on the wafer surface is also low, in the 10 to 20 percent range. Any pressure from the taping, grinding, de-taping is exerted on just the one die only, eventually resulting in cracked membranes and/or ripped off membranes, for example. By adding structures with a structure height greater than or equal to the device height mechanical stress during manufacturing can be stirred away from the more stress sensible device, such as a pressure sensor, for example. In other words the overall height of the chip is increased in order to reduce pressure on the device during manufacturing the chip.
In another example embodiment, the set of structures are coupled to the substrate.
This way the chip can be manufactured in a common process at wafer-level, e.g. in a CMOS process.

In another example embodiment, the set of structures are coupled to the second side of the passivation layer.

According to the invention the structures are decoupling capacitors and are arranged on at least four sides of the device.

The structures are grouped around the device in order to protect from mechanical stress acting from different directions.

In alternative examples not forming part of the invention the structure types include at least one of: a rigid structure, a closed device, a spacer structure, a support structure, a reference capacitor, a polyimide, or a structure that does not contain a cavity.
Rigid structures may include closed devices such as reference capacitors. Structures such as support structures (or others) can be implemented in various shapes such as square, circular, rectangular, oval etc. The structures may or may not be connected with each other or electrically connected to the substrate and/or device. If not connected then they will only be used as support structure. The support structures may have electrical functionality such as reference capacitors, or no electrical functionality, e.g. as rigid support structures or dummy structures only. Reference capacitors could not have a cavity, for example, and, thus, are not sensitive to pressure.

In an example embodiment, the structures completely surround the device.

According to the invention, the structures are grouped around the device in order to protect it from mechanical stress coming from different directions. The term "completely surround" can be understood as being arranged around the device from all side.

There may be a gap between individual structures. Or the structures may surround the device completely in the sense that they leave no gap and are, thus, continuous.

According to the invention, the set of structures are only configured to have a structure height greater than or equal to the device height.
This way mechanical stress acting on the chip can be more evenly divided and spread over the chip or device and structures. For example, structure height of different structures can essentially be the same within the set of structures. The device height may be in the range of some micrometers, 1 to 5 micrometers, for example. If structure height is greater than the device height then pressure may essentially only act on the structures. Pressure acting on the device can thus be decreased considerably or even avoided at all.
In another example embodiment, the set of structures include a surface configured to receive an adhesive tape.
The adhesive tape constitutes an additional structure to receive and divert pressure throughout manufacture of the device.
Another example embodiment, further comprising the adhesive tape, and the tape is coupled only to the structures.
In another example embodiment additional support structures can be provided. In case support structures are not enough an extra standoff height can be obtained by adding a polyimide (or PBO, or any other material to reduce die-package interaction in assembly) over the support structures. At the same time the sensitive device, such as pressure transducers, are kept free of material. Due to the extra height introduced, e.g. by additional support structures made from the material mentioned above, pressure exerted on the device will be further diverted or reduced. Optionally, but not forming part of the invention, some support structures could be left out, e.g. in case reference capacitors are created in the interconnect, and extra standoff height can be created by applying material such as polyimide only, keeping the sensitive device, such as pressure transducers, free of material.
In another example embodiment, the device is at least one of: a transducer, a MEMS device, or a pressure sensor.
Especially pressure sensitive devices such as transducers (sealed devices) may bend downward due to ambient pressure. Thus, using the proposed structures to divert pressure there is less chance of mechanical deformation, e.g. of a membrane, a transducer, a MEMS device, or a pressure sensor. Mechanical stress gets more evenly divided and spread over the structures and/or wafer. The device may have square or rectangular configuration.
The device can be a differential pressure sensor, for example. The differential pressure sensor comprises a cavity having a base including a base electrode and a first membrane suspended above the base which includes a membrane electrode. The first membrane is sealed with the cavity defined beneath the first membrane. A first pressure input port is coupled to the space above the sealed first membrane. A capacitive read out system for measuring the capacitance can be arranged between the base electrode and membrane electrode. An interconnecting channel is arranged between the cavity and a second pressure input port.
Such differential pressure sensor provides two port connections to the area above and below the membrane. In this way, a differential pressure sensor is provided. The sensor can be integrated on top of an integrated circuit, used as the read-out circuit. There can be one or more pressure sensitive membranes, and they can be read out capacitive in an absolute manner or differentially.
For example, the ability to integrate the pressure sensitive membrane on top of an integrated circuit enables a reduction in form factor, with a single die solution. This gives a reduction of expensive Si area compared to a "next to IC" option. This has significant implications to the design and operation of the sensor and the sensor read-out.

According to the invention the substrate includes an integrated circuit on the first side of the passivation layer.
The integrated circuit could, for example, be used as a read-out circuit or other types of signal processing. For example, the integrated circuit is electrically connected to the device and provides connections and means to operate the device.

According to the invention the integrated circuit is an analog circuit and the structures are decoupling capacitors. In another example embodiment, the integrated circuit does not include the structures.

In another example embodiment, the chip further comprises a seal layer on top of the device.

The invention also concerns a method for fabricating a chip as specified in claim 11. The chip includes a substrate. A first side of a passivation layer is coupled to the substrate. A device with a device height, a membrane and a cavity is arranged on the passivation layer, wherein a first device surface is coupled to a second side of the passivation layer which is opposite to the first side of the passivation layer. A set of structures is coupled to the second side of the passivation layer and configured to have a structure height greater than or equal to the device height.
The method comprises the following steps: applying tape to a first side of the chip, grinding a second side of the chip opposite to the first side; and the structures are configured to spread a pressure exerted during the grinding process so as to avoid damaging the device.
Another example embodiment, further comprises removing the tape from the chip; and the structures are configured to prevent removal of the tape from damaging the device.
The proposed principle allows to make use of common assembly technology. In one aspect the proposed solution enables a higher density of support structures and/or reference capacitors structures sticking out on top of a die, for example. Thereby the overall stress and mechanical impact on the device, such as pressure transducers, is reduced. In a second aspect, a stand-off height between device and applied mechanical stress is increased by implementing a stress reduction layer, e.g. polyimide structures. In a third aspect polyimide is used as a stress relief layer and to create more stand-off height without changing the top metal electrode density.

Further advantages of the proposed principle relate to better dry etching uniformity across a wafer which leads to less performance variation. Performance is improved due to less variation. In other prior solutions typically 80 to 90% of a top electrode metal needs to be removed during etching, while simultaneously narrow release holes are etched (with high iso/dense differences) in the 10% of the resist which define membranes. Furthermore, time for top electrode metal dry etching is reduced, which can increase throughput in a fab. Due to higher amount of reference capacitors, for example, also a better uniformity over the wafer can be achieved which allows for improved process control and hence better performance control. Better stress control over the wafer leads to less performance variation. As a majority of deposited metal may stay on the wafer, the stress will be more closely resembling the blanket layer stress. This can lead to better prediction of final performance.

The above discussion is not intended to represent every example embodiment or every implementation within the scope of the current or future claim sets. The figures and detailed description that follow also exemplify various example embodiments.

In the following, the principle presented above is described in further detail with respect to drawings, in which exemplary embodiments are presented.
- Figure 1A: shows an example wafer portion,
- Figure 1B: shows a first example set of chip structures,
- Figure 2: shows a second example set of chip structures,
- Figures 3A and 3B: show a third and a fourth example sets of chip structures,
- Figure 4A: shows an example set of top electrode process steps for fabricating a pressure sensor without an additional structure,
- Figure 4B: shows an example set of top electrode process steps for fabricating a pressure sensor with an additional structure,
- Figure 5A: shows the first example set of chip structures,
- Figure 5B: shows a fifth example chip structure,
- Figure 6: shows a cross-section of the fifth example set of chip structures,
- Figure 7A: shows the example wafer portion,
- Figure 7B: shows a sixth example chip structure,
- Figure 8: shows a cross-section of the sixth example set of chip structures and
- Figure 9: shows an example method of manufacturing chip structures.
While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the scope of the appended claims are covered as well.
Pressure sensors transducers placed on or near the surface of a silicon substrate, or on top of CMOS, BiCMOS, Bipolar, High Voltage and integrated circuits, however, are much more susceptible to damage during later back-end processing steps.
Such pressure sensor transducers not only stick out from top surface (e.g. by about 3 µm) of the substrate, but also are slightly deflected under pressure thus exposing their edges to even more concentrated mechanical pressure and stress during wafer back-end processes, such as grinding, so that after back-end processing de-taping can substantially damage, break, crack or detach the pressure sensor membranes or other parts.
For example, in some example embodiments there is a single transducer per die. Thus on a full wafer, pressure sensors may only take up 10-20% of the die surface area, and pressure from later taping/ grinding/ de-taping is concentrated on these pressure sensors, thereby causing damage.

Adding structures to the other 80-90% of the wafer surface at the Front-End, would spread the pressure exerted during the grinding/thinning process amongst the structures and the transducers and thereby reduce broken, damaged or detached membranes during the Back-End process.

These additional structures can also be electronically or mechanically functional (e.g. serve as reference capacitors).

Embodiments of such a ruggedized pressure sensor design are compatible with main stream assembly technology.

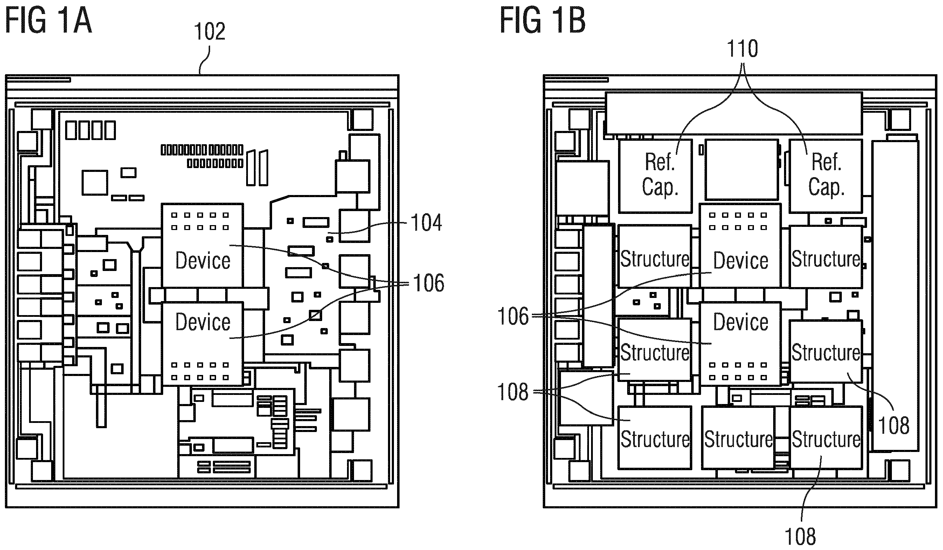

Figure 1A is an example wafer portion 102. The wafer portion 102 includes a substrate, an integrated circuit 104, and two devices 106. In other example embodiments there may only be one device 106. The devices in one example embodiment are structures with cavities, as is discussed below. Since the devices 106 are on top of a passivation layer on the wafer 102, the devices 106 are at a greater height than the surrounding passivation layer. As such, the devices 106 are more susceptible to significant pressure gradients and thus damage during processing of the wafer 102, such as during back-end grinding.

Figure 1B is a first example set of chip (e.g. a die) structures 108 and 110 positioned about the devices 106. The structures 108 and 110 are of a height such that pressure gradients and/or damage to the devices 106 is lessened or eliminated during processing of the wafer 102, since the devices 106 tend to be sticking out on top of the chip.

While in one embodiment, the devices 106 may be a pressure sensor, a transducer, or a MEMS device, in alternate embodiments, the devices may be any structure that needs to be protected, or is susceptible to breakage, during processing of the wafer 102.
The structures 108 and 110 distribute the substantial grinding pressure during thinning of the wafer 102 on the back-side. The structures 108 and 110 provide additional contact points (i.e. supports) for adhesive tape and wafer fabrication tools used during the back-grinding process.
The structures 108 and 110 may be formed as various structural types, including: a rigid structure, a closed device, a spacer structure, a support structure, a reference capacitor 110, a decoupling capacitor, a polyimide, or a structure that does not contain a cavity. However, according to the invention the structures are all decoupling capacitors which are arranged at least on four sides of the device.

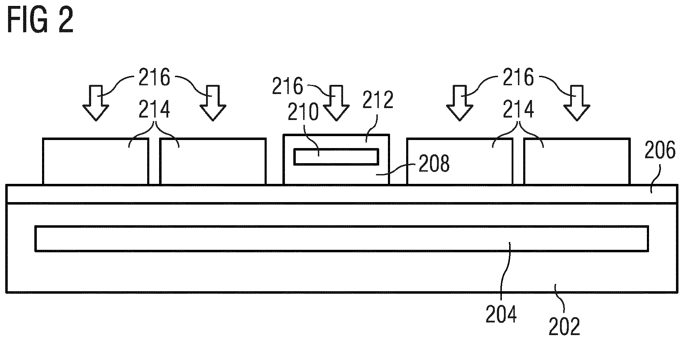

Figure 2 is a second example set of chip structures. Figure 2 shows a substrate 202 (e.g. Silicon) including an integrated circuit 204. On top of the substrate 202 is a passivation layer 206. On top of the passivation layer 206 is a device 208 having a cavity 210 and a membrane 212. In devices 208 which are sealed, such as pressure sensor transducers, the membrane 212 deflects due to pressure of the ambient surroundings. Such membrane 212 deflection exposes edges of the membrane 212 to greater grinding pressures, which push the edges further into the adhesive tape used during grinding, such that when the tape is removed the membrane can be damaged or even ripped off entirely.

Surrounding the device 208 is a set of structures 214. As introduced above the structures 214 completely or somewhat protect the device 208 from back-grinding pressure 216 and can have a height such that the adhesive tape does not contact the edges of the membrane 212. In some example embodiments, the device 208 and structures 214 may be covered with a sealing layer. In one example embodiment, either or both the device 208 and structures 214 are electrically connected to the integrated circuit 204, perhaps using tungsten plugs and/or slits. Such an electrical connection to the structures 214 would be more likely if the structures 214 were reference capacitors or some other electrical devices.
While the device 208 is fabricated on top of the passivation layer 206, the structures 214 may be fabricated either on top of or underneath of the passivation layer 206. In one example embodiment, the set of structures are all configured to have a structure height greater than or equal to the device's height. In alternate examples not forming part of the invention some of the structures may have a height less than the device's height, depending upon tooling used during back-end wafer processing.
The set of structures include a surface configured to receive an adhesive tape which may or may not contact the device 208. Thus in some embodiments, the tape is coupled only to the structures.
In some example embodiments, the integrated circuit 204 is an analog circuit and the structures are decoupling capacitors which form part of the integrated circuit 204, while in other example embodiments, the structures are not part of the integrated circuit 204.

Dual use of the structures 214 as decoupling capacitors for analog circuit ASIC optimization, can help reduce noise in such analog circuits while simultaneously protecting the device 208. Such analog designs need decoupling capacitance to reduce noise and overcome transients on the supply due to fast switching of digital, causing possible power down of the chip. In IC manufacturing, decoupling capacitors are made below the passivation layer 206 in the substrate 202. However, such capacitors also use up extra Silicon area and in the case of MIM caps even require extra masks. By moving such decoupling capacitors structures above the passivation layer 206, additional substrate 202 space for analog circuit structures is freed-up.

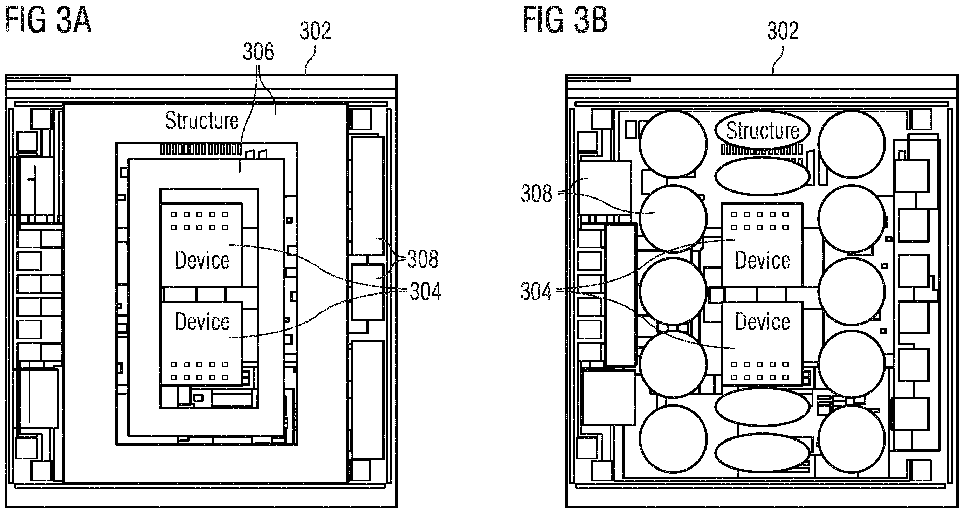

Figures 3A and 3B are third and fourth example sets of chip structures. Figure 3A shows a wafer portion 302 having devices 304 and both surrounding structures 306 and standalone structures 308. Figure 3B shows the wafer portion 302 where the stand-alone structures 308 can be a variety of shapes (e.g. square, circular, rectangular, oval, etc.). Design selection between the surrounding structures 306 and the stand-alone structures 308 depends upon the fragility of the devices 304 and other fabrication concerns. In alternate embodiments, the surrounding structures 306 can also be a variety of shapes (e.g. square, circular, rectangular, oval, etc.).

According to the invention the structures are of a same type and are on at least four sides of the device, while in other examples not forming part of the invention the structures may be of different types and positioned only on certain sides of the device 304.

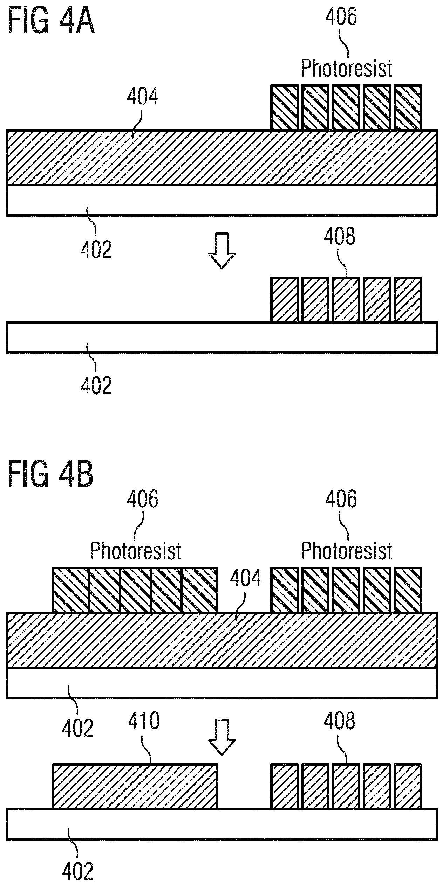

Figures 4A is an example set of top electrode process steps for fabricating a pressure sensor without an additional structure 410. Figures 4B is an example set of top electrode process steps for fabricating a pressure sensor with the additional structure 410. Inclusion of the additional structure 410 has a number of benefits that go beyond just reducing pressure on a fragile device.

In Figures 4A and 4B part of a wafer portion is shown, including a sacrificial layer 402 having a metallization layer 404 on top. Photoresist 406 masks the metallization layer 404, thereby forming just a top electrode 408 in Figure 4A or both the top electrode 408 and the additional structure 410 in Figure 4B.

This example embodiment is beneficial for at least the following reasons. Currently 80-90% of the top electrode metal in the field needs to be removed during etch, while simultaneously very narrow release holes are etched (very high ISO/dense differences) in the 10% of the resist which defines the membranes. With the addition of reference capacitors as structures, the top electrode metal dry etching time is reduced since a much lower percentage of the metal is removed over the surface of the wafer. This results in better dry etching uniformity across the wafer.

Also due to higher amount of reference capacitors, a better idea of uniformity over the wafer (process control end hence better performance control) is obtained. Potentially better stress control over the wafer results in less performance variation, since the majority of the deposited metal now stays on the wafer. The stress will be more closely resembling the blanket layer stress, leading to better prediction of final performance.

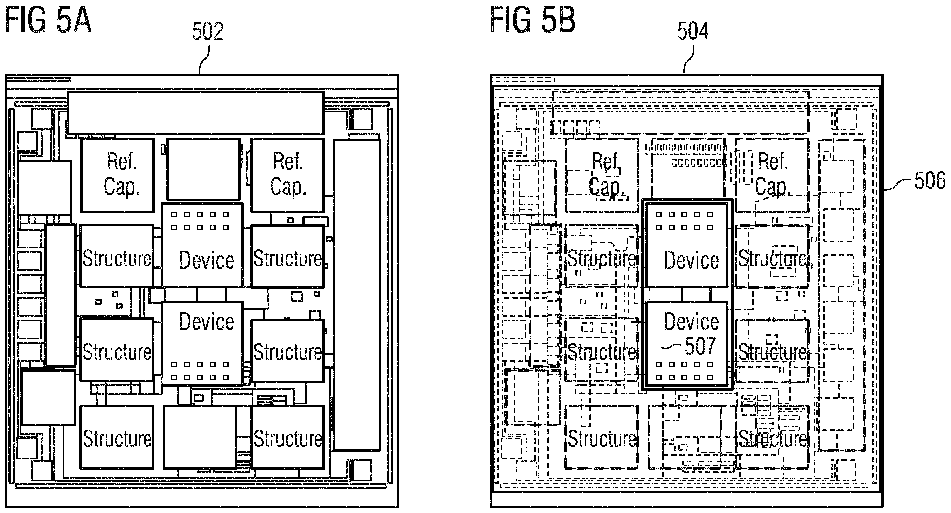

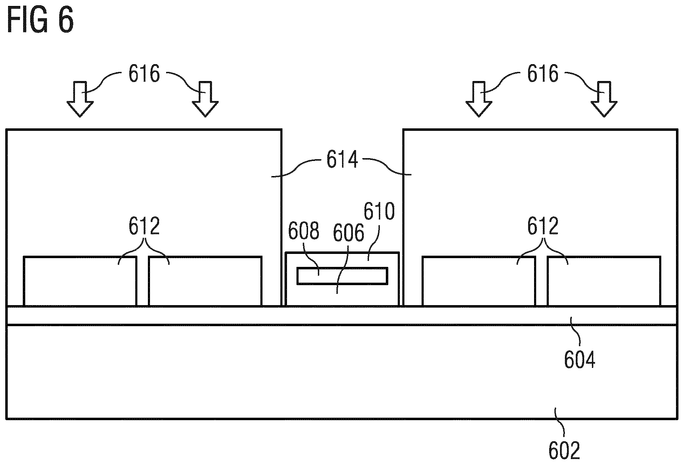

Figure 5A shows 502 the first example set of chip structures previously shown in Figure 1B. Figure 5B is a fifth example set of chip structures 504 including both a set of structures and an additional structure. In Figure 5B the additional structure can be a polyimide layer. This embodiment is further described in Figure 6.

Figure 6 shows a cross-section of the fifth example set of chip structures 504. The fifth example 504 includes a substrate 602. On top of the substrate 602 is a passivation layer 604. On top of the passivation layer 604 is a device 606 having a cavity 608 and a membrane 610. Surrounding the device 606 is a set of structures 612. On top of the structures 612 are additional structures 614.

The additional structures 614 further increase a stand-off height between the device 606 and applied mechanical stress from back-grinding pressure 616. These additional structures 614, which can be made from polyimide, PBO, or any other material which reduces die-package stress and/or interaction during package assembly. The additional structures 614 function as a further stress reduction layer, which in some examples can be on the order of 5µm in height. In this fifth example 504 there will be virtually no back-grinding pressure 616 exerted on the device 606.

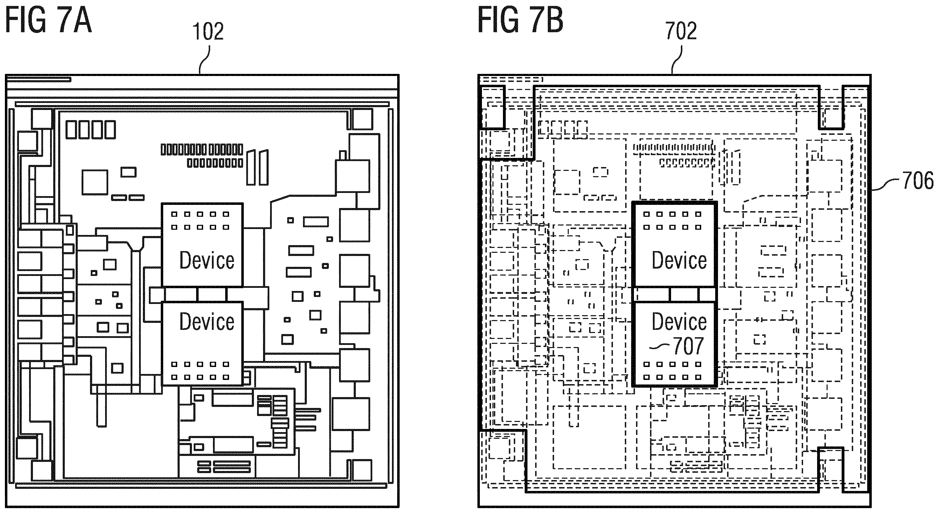

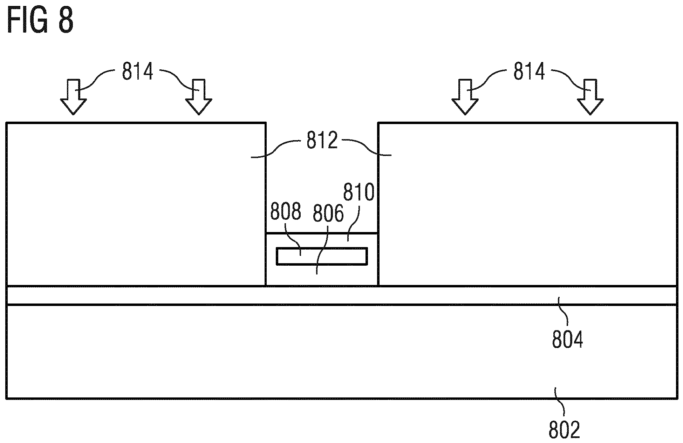

Figure 7A shows the example wafer portion 102 previously shown in Figure 1A. Figure 7B is a sixth example chip structure 702. This embodiment is further described in Figure 8.

Figure 8 is a cross-section of the sixth example set of chip structures 702. The sixth example 702 includes a substrate 802. On top of the substrate 802 is a passivation layer 804. On top of the passivation layer 804 is a device 806 having a cavity 808 and a membrane 810. Surrounding the device 806 is a set of structures 812.

In this sixth example 702, only a structure 812 such as polyimide is used as a stress relief layer by creating more stand-off height.

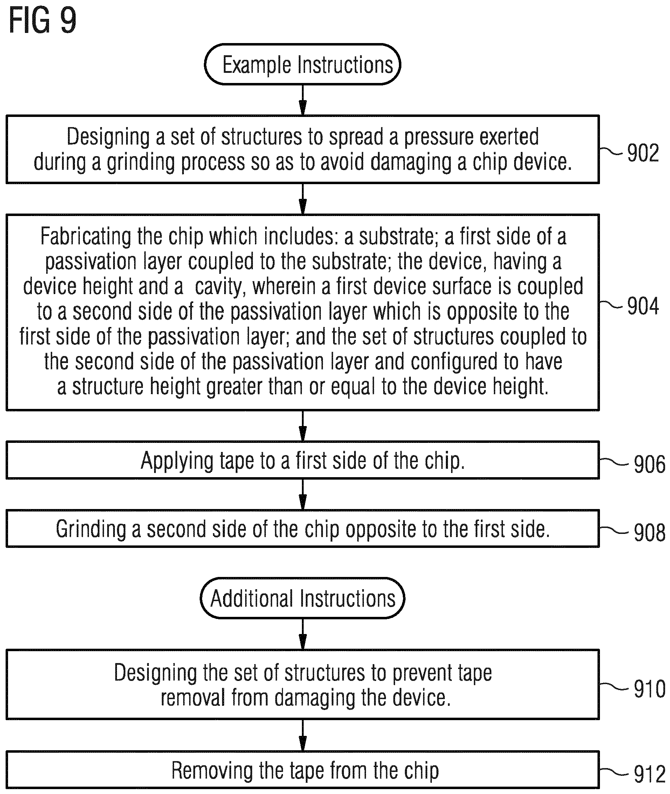

Figure 9 is an example method of manufacturing chip structures. The order in which the method elements are discussed does not limit the order in which other example embodiments implement these elements.

A first example method element begins in 902, designing a set of structures to spread a pressure exerted during a grinding process so as to avoid damaging a chip device.

Then in 904, fabricating the chip which includes: a substrate; a first side of a passivation layer coupled to the substrate; the device, having a device height and a cavity, wherein a first device surface is coupled to a second side of the passivation layer which is opposite to the first side of the passivation layer; and the set of structures coupled to the second side of the passivation layer and configured to have a structure height greater than or equal to the device height.

In 906, applying tape to a first side of the chip. Next in 908, grinding a second side of the chip opposite to the first side.

The method elements can be augmented with one or more of the following additional elements presented in no particular order.

The additional method elements include: 910 - designing the set of structures to prevent tape removal from damaging the device; and 912 - removing the tape from the chip.

The method elements in the above Figures can be executed in any order, unless a specific order is explicitly stated. Also, those skilled in the art will recognize that while one example method has been discussed, the material in this specification can be combined in a variety of ways to yield other examples as well, and are to be understood within a context provided by this detailed description.

In this specification, example embodiments have been presented in terms of a selected set of details. However, a person of ordinary skill in the art would understand that many other example embodiments may be practiced which include a different selected set of these details. It is intended that the following claims cover all possible example embodiments.

### Reference numerals

- 102: wafer portion
- 104: integrated circuit
- 106: device
- 108: structure
- 110: structure
- 202: substrate
- 204: integrated circuit
- 206: passivation layer
- 208: device
- 210: cavity
- 212: membrane
- 214: structure
- 216: back-grinding pressure
- 302: wafer portion
- 304: devices
- 306: structure
- 308: standalone structure
- 402: sacrificial layer
- 404: metallization layer
- 406: photoresist
- 408: top electrode
- 410: structure
- 502: chip structure
- 504: chip structure
- 602: substrate
- 604: passivation layer
- 606: device
- 608: cavity
- 610: membrane
- 612: structure
- 614: structure
- 616: back-grinding pressure
- 702: chip structure
- 802: substrate
- 804: passivation layer
- 806: device
- 808: cavity
- 810: membrane
- 812: structure
- 902: process step
- 904: process step
- 906: process step
- 908: process step
- 910: process step
- 912: process step

## Claims

1. Chip, comprising:
- a substrate (102, 202, 302, 602, 802);
- a first side of a passivation layer (206, 604, 804) coupled to the substrate (102, 202, 302, 602, 802);
- a device (106, 208, 304, 606, 806), having a device height, a membrane (212, 610, 810) and a cavity (210, 608, 808), wherein a first device surface is coupled to a second side of the passivation layer (206, 604, 804) which is opposite to the first side of the passivation layer (206, 604, 804); and
- a set of structures (108, 110, 214, 306, 410, 502, 504, 612, 614, 702, 812) coupled to the chip and configured to have a structure height greater than or equal to the device height, and wherein the structures are grouped around the device (106, 208, 304, 606, 806); wherein
- the structures (108, 110, 214, 306, 410, 502, 504, 612, 614, 702, 812) are of a same type and are arranged at least on four sides of the device,
- the substrate (102, 202, 302, 602, 802) includes an integrated circuit on the first side of the passivation layer (206, 604, 804),
- the integrated circuit is an analog circuit and the structures (108, 110, 214, 306, 410, 502, 504, 612, 614, 702, 812) are decoupling capacitors.

2. Chip according to claim 1, wherein the set of structures (108, 110, 214, 306, 410, 502, 504, 612, 614, 702, 812) are coupled to the substrate (102, 202, 302, 602, 802).

3. Chip according to claim 1 or 2, wherein the set of structures (108, 110, 214, 306, 410, 502, 504, 612, 614, 702, 812) coupled to the second side of the passivation layer (206, 604, 804).

4. Chip according to one of the preceding claims, wherein the structures (108, 110, 214, 306, 410, 502, 504, 612, 614, 702, 812) completely surround the device.

5. Chip according to one of the preceding claims, wherein the set of structures (108, 110, 214, 306, 410, 502, 504, 612, 614, 702, 812) are configured to have a structure height greater than or equal to the device height.

6. Chip according to one of the preceding claims, wherein the set of structures (108, 110, 214, 306, 410, 502, 504, 612, 614, 702, 812) include a surface configured to receive an adhesive tape.

7. Chip according to claim 6, further comprising the adhesive tape, wherein the tape is coupled only to the structures (108, 110, 214, 306, 410, 502, 504, 612, 614, 702, 812) .

8. Chip according to one of the preceding claims, wherein the device (106, 208, 304, 606, 806) is at least one of: a transducer, a MEMS device, or a pressure sensor.

9. Chip according to one of the preceding claims, further comprising a seal layer on top of the device (106, 208, 304, 606, 806).

10. Chip according to one of the preceding claims, wherein the integrated circuit and the structures (108, 110, 214, 306, 410, 502, 504, 612, 614, 702, 812) are separate.

11. A method for fabricating a chip, wherein the chip includes:
- a substrate (102, 202, 302, 602, 802);
- a first side of a passivation layer coupled to the substrate (102, 202, 302, 602, 802);
- a device (106, 208, 304, 606, 806), having a device height, a membrane (212, 610, 810) and a cavity (210, 608, 808), wherein a first device surface is coupled to a second side of the passivation layer (206, 604, 804) which is opposite to the first side of the passivation layer (206, 604, 804); and
- a set of structures (108, 110, 214, 306, 410, 502, 504, 612, 614, 702, 812) coupled to the second side of the passivation layer (206, 604, 804) and configured to have a structure height greater than or equal to the device height, and wherein the structures are grouped around the device (106, 208, 304, 606, 806); and
the method comprising:
- applying tape to a first side of the chip, wherein the first side carries the device (106, 208, 304, 606, 806),
- grinding a second side of the chip opposite to the first side; and wherein the structures are grouped around the device such as to spread a pressure exerted during the grinding process.

12. The method of claim 11 further comprising the steps of:
- removing the tape from the chip; and wherein the structures (108, 110, 214, 306, 410, 502, 504, 612, 614, 702, 812) are configured to prevent removal of the tape from damaging the device (106, 208, 304, 606, 806).

## Patentansprüche

1. Chip, Folgendes aufweisend:
- ein Substrat (102, 202, 302, 602, 802);
- eine erste Seite einer Passivierungsschicht (206, 604, 804), die mit dem Substrat (102, 202, 302, 602, 802) gekoppelt ist;
- eine Vorrichtung (106, 208, 304, 606, 806), die eine Vorrichtungshöhe, eine Membran (212, 610, 810) und einen Hohlraum (210, 608, 808) hat, wobei eine erste Vorrichtungsfläche mit einer zweiten Seite der Passivierungsschicht (206, 604, 804) gekoppelt ist, die der ersten Seite der Passivierungsschicht (206, 604, 804) entgegengesetzt ist; und
- einen Satz Strukturen (108, 110, 214, 306, 410, 502, 504, 612, 614, 702, 812), der mit dem Chip gekoppelt und dazu ausgelegt ist, eine Strukturhöhe zu haben, die größer als die oder gleich der Vorrichtungshöhe ist, und wobei die Strukturen um die Vorrichtung (106, 208, 304, 606, 806) gruppiert sind; wobei
- die Strukturen (108, 110, 214, 306, 410, 502, 504, 612, 614, 702, 812) vom selben Typ und zumindest auf vier Seiten der Vorrichtung angeordnet sind,
- das Substrat (102, 202, 302, 602, 802) eine integrierte Schaltung auf der ersten Seite der Passivierungsschicht (206, 604, 804) umfasst,
- die integrierte Schaltung eine analoge Schaltung ist und die Strukturen (108, 110, 214, 306, 410, 502, 504, 612, 614, 702, 812) Entkopplungskondensatoren sind.

2. Chip nach Anspruch 1, wobei der Satz Strukturen (108, 110, 214, 306, 410, 502, 504, 612, 614, 702, 812) mit dem Substrat (102, 202, 302, 602, 802) gekoppelt ist.

3. Chip nach Anspruch 1 oder 2, wobei der Satz Strukturen (108, 110, 214, 306, 410, 502, 504, 612, 614, 702, 812) mit der zweiten Seite der Passivierungsschicht (206, 604, 804) gekoppelt ist.

4. Chip nach einem der vorhergehenden Ansprüche, wobei die Strukturen (108, 110, 214, 306, 410, 502, 504, 612, 614, 702, 812) die Vorrichtung vollständig umgeben.

5. Chip nach einem der vorhergehenden Ansprüche, wobei der Satz Strukturen (108, 110, 214, 306, 410, 502, 504, 612, 614, 702, 812) dazu ausgelegt ist, eine Höhe zu haben, die größer als die oder gleich der Vorrichtungshöhe ist.

6. Chip nach einem der vorhergehenden Ansprüche, wobei der Satz Strukturen (108, 110, 214, 306, 410, 502, 504, 612, 614, 702, 812) eine Fläche umfasst, die dazu ausgelegt ist, ein Klebeband aufzunehmen.

7. Chip nach Anspruch 6, darüber hinaus das Klebeband aufweisend, wobei das Band nur mit den Strukturen (108, 110, 214, 306, 410, 502, 504, 612, 614, 702, 812) verbunden ist.

8. Chip nach einem der vorhergehenden Ansprüche, wobei es sich bei der Vorrichtung (106, 208, 304, 606, 806) zumindest um eine Vorrichtung aus: einem Transducer, einer MEMS-Vorrichtung oder einem Drucksensor handelt.

9. Chip nach einem der vorhergehenden Ansprüche, darüber hinaus eine Dichtungsschicht oben auf der Vorrichtung (106, 208, 304, 606, 806) aufweisend.

10. Chip nach einem der vorhergehenden Ansprüche, wobei die integrierte Schaltung und die Strukturen (108, 110, 214, 306, 410, 502, 504, 612, 614, 702, 812) separat sind.

11. Verfahren zum Herstellen eines Chips, wobei der Chip umfasst:
- ein Substrat (102, 202, 302, 602, 802);
- eine erste Seite einer Passivierungsschicht, die mit dem Substrat (102, 202, 302, 602, 802) gekoppelt ist;
- eine Vorrichtung (106, 208, 304, 606, 806), die eine Vorrichtungshöhe, eine Membran (212, 610, 810) und einen Hohlraum (210, 608, 808) hat, wobei eine erste Vorrichtungsfläche mit einer zweiten Seite der Passivierungsschicht (206, 604, 804) gekoppelt ist, die der ersten Seite der Passivierungsschicht (206, 604, 804) entgegengesetzt ist; und
- einen Satz Strukturen (108, 110, 214, 306, 410, 502, 504, 612, 614, 702, 812), der mit der zweiten Seite der Passivierungsschicht (206, 604, 805) gekoppelt und dazu ausgelegt ist, eine Strukturhöhe zu haben, die größer als die oder gleich der Vorrichtungshöhe ist, und wobei die Strukturen um die Vorrichtung (106, 208, 304, 606, 806) gruppiert sind; und
wobei das Verfahren umfassst:
- Anbringen eines Bands auf einer ersten Seite des Chips, wobei die erste Seite die Vorrichtung (106, 208, 304, 606, 806) trägt,
- Schleifen einer der ersten Seite entgegengesetzten zweiten Seite des Chips; und wobei die Strukturen so um die Vorrichtung gruppiert sind, dass sie einen während des Schleifprozesses ausgeübten Druck verteilen.

12. Verfahren nach Anspruch 11, darüber hinaus die folgenden Schritte umfassend:
- Entfernen des Bands vom Chip; und wobei die Strukturen (108, 110, 214, 306, 410, 502, 504, 612, 614, 702, 812) dazu ausgelegt sind, zu verhindern, dass das Entfernen des Bands die Vorrichtung (106, 208, 304, 606, 806) beschädigt.

## Revendications

1. Puce, comprenant :
- un substrat (102, 202, 302, 602, 802) ;
- un premier côté d'une couche de passivation (206, 604, 804) couplé au substrat (102, 202, 302, 602, 802) ;
- un dispositif (106, 208, 304, 606, 806), ayant une hauteur de dispositif, une membrane (212, 610, 810) et une cavité (210, 608, 808), sachant qu'une première surface de dispositif est couplée à un deuxième côté de la couche de passivation (206, 604, 804) qui est opposé au premier côté de la couche de passivation (206, 604, 804) ; et
- un ensemble de structures (108, 110, 214, 306, 410, 502, 504, 612, 614, 702, 812) couplé à la puce et configuré pour avoir une hauteur de structure supérieure ou égale à la hauteur de dispositif, et sachant que les structures sont groupées autour du dispositif (106, 208, 304, 606, 806) ; sachant que
- les structures (108, 110, 214, 306, 410, 502, 504, 612, 614, 702, 812) sont d'un même type et agencées au moins sur quatre côtés du dispositif,
- le substrat (102, 202, 302, 602, 802) inclut un circuit intégré sur le premier côté de la couche de passivation (206, 604, 804),
- le circuit intégré est un circuit analogique et les structures (108, 110, 214, 306, 410, 502, 504, 612, 614, 702, 812) sont des condensateurs de découplage.

2. Puce selon la revendication 1, sachant que l'ensemble de structures (108, 110, 214, 306, 410, 502, 504, 612, 614, 702, 812) est couplé au substrat (102, 202, 302, 602, 802).

3. Puce selon la revendication 1 ou 2, sachant que l'ensemble de structures (108, 110, 214, 306, 410, 502, 504, 612, 614, 702, 812) est couplé au deuxième côté de la couche de passivation (206, 604, 804).

4. Puce selon l'une des revendications précédentes, sachant que les structures (108, 110, 214, 306, 410, 502, 504, 612, 614, 702, 812) entourent entièrement le dispositif.

5. Puce selon l'une des revendications précédentes, sachant que l'ensemble de structures (108, 110, 214, 306, 410, 502, 504, 612, 614, 702, 812) est configuré pour avoir une hauteur de structure supérieure ou égale à la hauteur de dispositif.

6. Puce selon l'une des revendications précédentes, sachant que l'ensemble de structures (108, 110, 214, 306, 410, 502, 504, 612, 614, 702, 812) inclut une surface configurée pour recevoir une bande adhésive.

7. Puce selon la revendication 6, comprenant en outre la bande adhésive, sachant que la bande est couplée uniquement aux structures (108, 110, 214, 306, 410, 502, 504, 612, 614, 702, 812).

8. Puce selon l'une des revendications précédentes, sachant que le dispositif (106, 208, 304, 606, 806) est au moins l'un de : un transducteur, un dispositif MEMS, ou un capteur de pression.

9. Puce selon l'une des revendications précédentes, comprenant en outre une couche d'étanchéité au-dessus du dispositif (106, 208, 304, 606, 806).

10. Puce selon l'une des revendications précédentes, sachant que le circuit intégré et les structures (108, 110, 214, 306, 410, 502, 504, 612, 614, 702, 812) sont séparées.

11. Procédé de fabrication d'une puce, sachant que la puce inclut :
- un substrat (102, 202, 302, 602, 802) ;
- un premier côté d'une couche de passivation couplé au substrat (102, 202, 302, 602, 802) ;
- un dispositif (106, 208, 304, 606, 806), ayant une hauteur de dispositif, une membrane (212, 610, 810) et une cavité (210, 608, 808), sachant qu'une première surface de dispositif est couplée à un deuxième côté de la couche de passivation (206, 604, 804) qui est opposé au premier côté de la couche de passivation (206, 604, 804) ; et
- un ensemble de structures (108, 110, 214, 306, 410, 502, 504, 612, 614, 702, 812) couplé au deuxième côté de la couche de passivation (206, 604, 804) et configuré pour avoir une hauteur de structure supérieure ou égale à la hauteur de dispositif, et sachant que les structures sont groupées autour du dispositif (106, 208, 304, 606, 806) ; et
le procédé comprenant :
- l'application d'une bande au premier côté de la puce, sachant que le premier côté porte le dispositif (106, 208, 304, 606, 806),
- le meulage d'un deuxième côté de la puce opposé au premier côté ; et sachant que les structures sont groupées autour du dispositif de façon à étaler une pression exercée pendant le processus de meulage.

12. Le procédé de la revendication 11, comprenant en outre les étapes de :
- enlèvement de la bande de la puce ; et sachant que les structures (108, 110, 214, 306, 410, 502, 504, 612, 614, 702, 812) sont configurées pour empêcher que l'enlèvement de la bande n'endommage le dispositif (106, 208, 304, 606, 806).
